# EUROPEAN PATENT SPECIFICATION

(11) **EP 4 462 762 B1**
(45) Date of publication and mention of the grant of the patent: **08.07.2026**
(21) Application number: 23803763.4
(22) Date of filing: 04.05.2023
(51) Int. Cl.: H04M 1/03, H05K 5/06, G06F 1/16, G06F 1/20, H04R 1/08, H04R 1/04, H04M 1/02

(54) **ELECTRONIC DEVICE COMPRISING TEMPERATURE SENSOR**
ELEKTRONISCHE VORRICHTUNG MIT TEMPERATURSENSOR
DISPOSITIF ÉLECTRONIQUE COMPRENANT UN CAPTEUR DE TEMPÉRATURE

(30) Priority: 13.05.2022 KR 20220058944; 02.06.2022 KR 20220067636
(43) Date of publication of application: 13.11.2024
(73) Proprietor: Samsung Electronics Co., Ltd, Suwon-si, Gyeonggi-do 16677 (KR)
(72) Inventor: JU, Wanjae, Suwon-si Gyeonggi-do 16677 (KR)
(74) Representative: Nederlandsch Octrooibureau
(86) International application number: PCT/KR2023/006126
(87) International publication number: WO 2023/219340

(56) References cited:
- JP-A- 2008 135 672
- JP-A- 2019 041 055
- KR-A- 20190 052 105
- KR-A- 20210 101 462
- US-A1- 2016 162 256
- US-A1- 2016 277 844
- US-A1- 2021 144 242

## Description

### Technical Field

Various embodiments set forth in the present disclosure relate to an electronic device including a temperature sensor.

### Background Art

Various types of electronic devices may be internally overheated due to heat generated by hardware or an increase in external temperature, and overheating of the electronic devices may degrade the hardware performance or damage internal components. In particular, as technology advances, the hardware performance of electronic devices increases, and issues in heat generation of electronic devices increase.

To prevent overheating issues, electronic devices structurally include a heat dissipation structure and/or control the operation of hardware by software based on the internal and external temperatures of the electronic devices. For example, an electronic device measures the temperature of the electronic device using a temperature sensor disposed therein and controls the operation of the electronic device based on the measured temperature.

US 2016/277844 Al discloses a transducer package including a circuit board having a port, an acoustic transducer disposed over the port and an environmental transducer disposed at the circuit board in the port.

### DISCLOSURE OF THE INVENTION

### Technical Solutions

To specify the external temperature of an electronic device, for example, temperature sensors are disposed in various positions inside the electronic device to measure the internal temperature and predict the external temperature of the electronic device based on the measured temperature. However, errors may occur in external temperature measurement depending on the environment and circumstance in which the electronic device is driven.

For example, if the electronic device has been in an idle state for a long time, the internal temperature and external temperature of the electronic device may be similar. However, in various situations in which, for example, the electronic device is driven for a long period of time, the power consumption of hardware temporarily increases, or the temperature outside the electronic device increases or decreases rapidly, it is difficult for a temperature sensor inside the electronic device to predict the temperature outside the electronic device.

Therefore, the electronic device needs to control the operation of hardware to discern the operation environment to cope with various situations, and particularly, to determine the external environment of the electronic device quickly and accurately.

Various embodiments of the present disclosure provide structures for disposing a temperature sensor in an area communicating with the outside so that the temperature sensor inside the electronic device may measure a change in the temperature outside the electronic device quickly and accurately.

The technical goals to be achieved through embodiments of the present disclosure are not limited to those described above, and other technical goals not mentioned above are clearly understood by one of ordinary skill in the art from the following description.

An electronic device according to the present invention is defined in the appended independent claim.

Further embodiments of the present invention are defined in the appended dependent claims.

### Effects of the Invention

According to various embodiments, an electronic device may measure a change in the external temperature more quickly and accurately using space into which air flows from the outside of a housing, and control the drive of hardware based on the measured external temperature.

Alternatively, according to various embodiments, disposing a temperature sensor in a component included in an electronic device for multiple uses, such as a microphone hole or speaker hole, without securing separate space for measuring the external temperature may contribute to slimming and miniaturizing electronic devices.

The effects of the electronic device according to various embodiments are not limited to the above-mentioned effects, and other unmentioned effects can be clearly understood from the following description by one of ordinary skill in the art.

### BRIEF DESCRIPTION OF DRAWINGS

FIG. 1 is a block diagram of an electronic device in a network environment according to various embodiments.
FIG. 2A is a plan perspective view of an electronic device according to an embodiment.
FIG. 2B is a rear perspective view of an electronic device according to an embodiment.
FIG. 3 is an exploded perspective view of an electronic device according to an embodiment.
FIG. 4A is a cross-sectional view of a temperature sensor, a printed circuit board (PCB), and a microphone element according to an embodiment.
FIG. 4B is a diagram illustrating various arrangement designs of a temperature sensor disposed on a microphone element according to an embodiment.
FIG. 5 is a cross-sectional view of the inside of an electronic device according to an embodiment.
FIG. 6 is a cross-sectional view of the inside of an electronic device according to an embodiment.
FIG. 7 is a cross-sectional view of the inside of an electronic device according to an embodiment.
FIG. 8A is a front view of an electronic device according to an embodiment.
FIG. 8B is a cross-sectional side view of an electronic device according to an embodiment.
FIG. 9A is a rear perspective view of an electronic device according to an embodiment.
FIG. 9B is a cross-sectional side view of a partial area of an electronic device according to an embodiment.
FIG. 9C is a cross-sectional side view of a partial area of an electronic device according to an embodiment.
FIG. 9D is a cross-sectional side view of a partial area of an electronic device according to an embodiment.

### BEST MODE FOR CARRYING OUT THE INVENTION

Hereinafter, embodiments will be described in detail with reference to the accompanying drawings. When describing the embodiments with reference to the accompanying drawings, like reference numerals refer to like components, and any repeated description related thereto will be omitted.

It should be appreciated that various embodiments of the disclosure and the terms used therein are not intended to limit the technical features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "at least one of A, B, or C", each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments may be implemented as software (e.g., a program 140) including one or more instructions that are stored in a storage medium (e.g., internal memory 136 or external memory 138) that is readable by a machine (e.g., an electronic device). For example, a processor of the machine (e.g., the electronic device) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

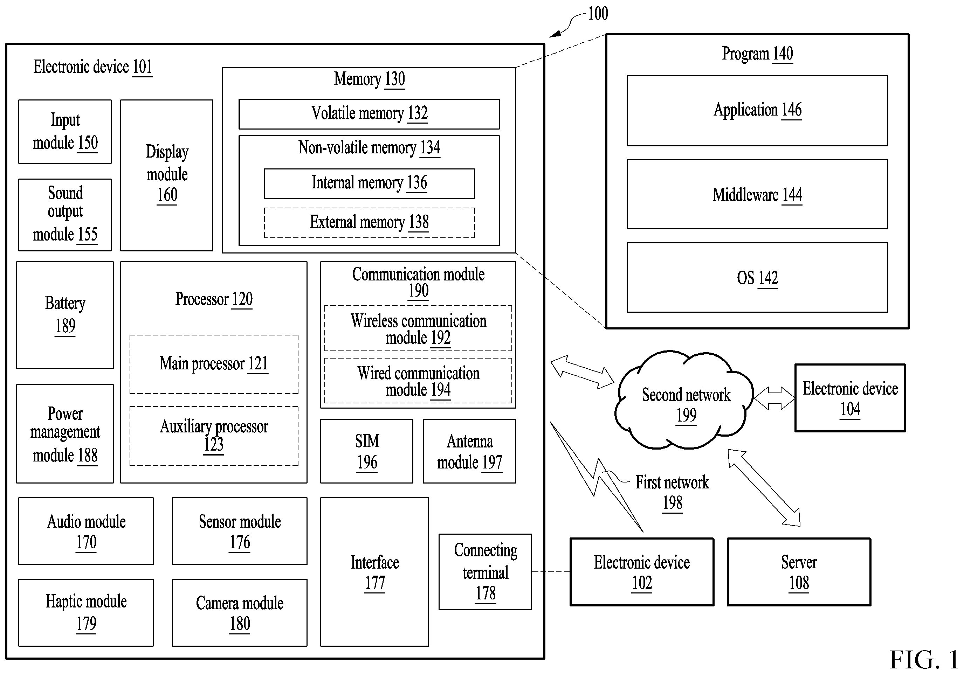

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a portion of data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented as separate from, or as part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state, or together with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An artificial intelligence model may be generated through machine learning. Such learning may be performed, e.g., by the electronic device 101 where the artificial intelligence is performed, or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network, or a combination of two or more thereof, but is not limited thereto. The artificial intelligence model may, additionally or alternatively, include a software structure other than the hardware structure.

The memory 130 may store various pieces of data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing a record. The receiver may be used to receive an incoming call. According to an embodiment, the receiver may be implemented separately from the speaker or as a portion of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to sense a touch, or a pressure sensor adapted to measure an intensity of a force incurred by the touch.

The audio module 170 may convert a sound into an electrical signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a portion of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that operate independently of the processor 120 (e.g., an application processor) and support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., a LAN or a wide area network (WAN))). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a fourth-generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., an external electronic device). According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the selected at least one antenna. According to an embodiment, another component (e.g., a radio frequency integrated circuit (RFIC)) other than the radiating element may be additionally formed as a portion of the antenna module 197.

According to various embodiments, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of a same type as, or a different type from, the electronic device 101. According to an embodiment, all or some of operations to be executed by the electronic device 101 may be executed at one or more of external electronic devices (e.g., the external electronic devices 102 and 104, or the server 108). For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smart phone), a computer device, a portable multimedia device, a portable medical device, a camera, a wearable device, or a home appliance. According to an embodiment of the disclosure, the electronic devices are not limited to those described above.

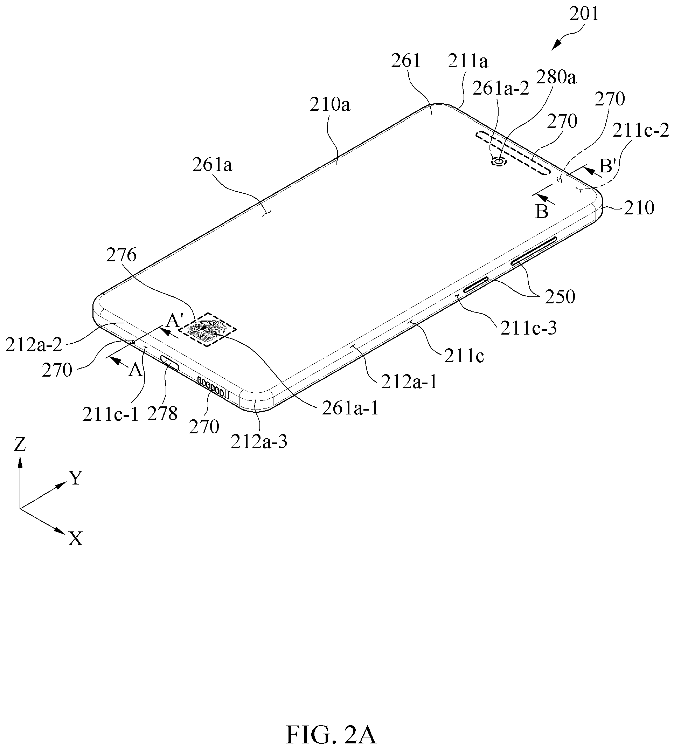

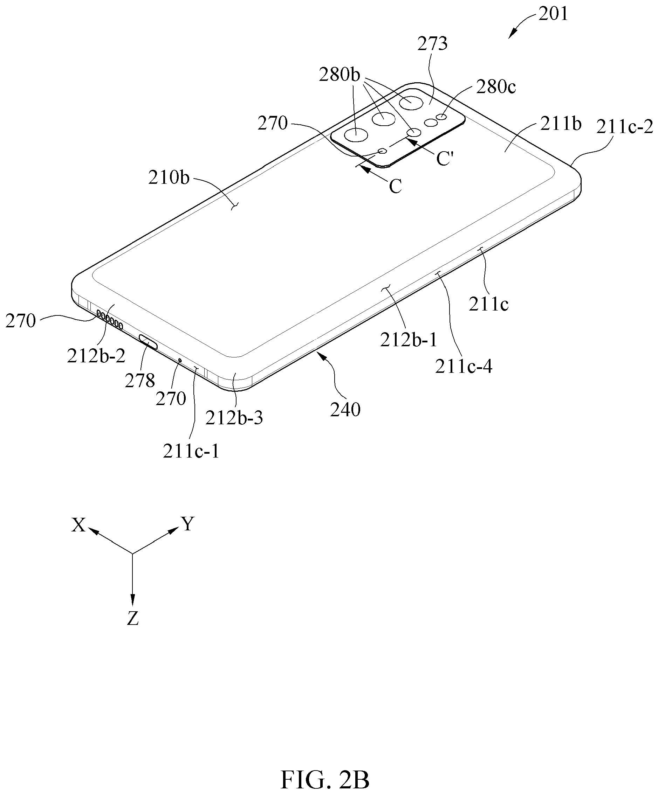

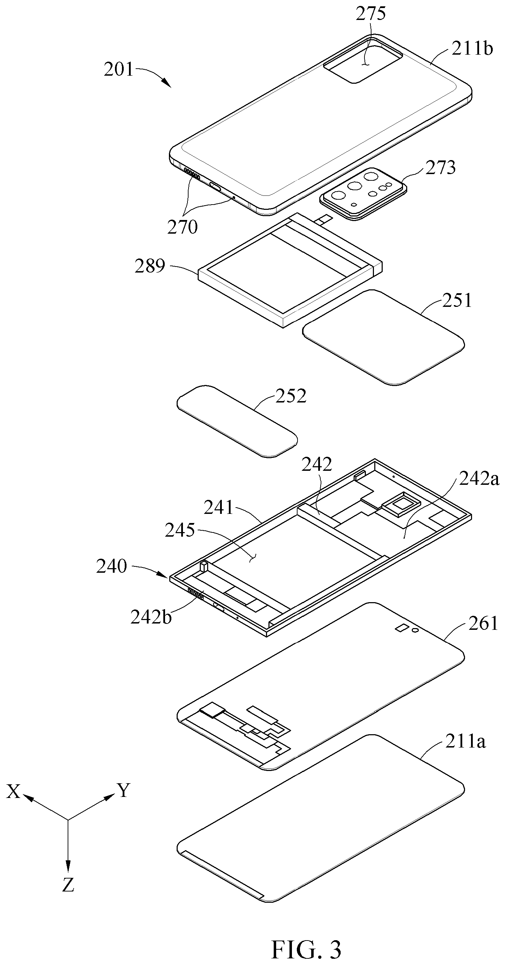

FIG. 2A is a front perspective view of an electronic device 201 according to an embodiment, FIG. 2B is a rear perspective view of the electronic device 201 according to an embodiment, and FIG. 3 is an exploded perspective view of the electronic device 201 according to an embodiment.

Referring to FIGS. 2A, 2B, and 3, the electronic device 201 (e.g., the electronic device 101 of FIG. 1) according to an embodiment may include a housing 210 forming an exterior and accommodating components therein, and the housing 210 may include a front surface 210a, a rear surface 210b, and a side surface 211c enclosing an inner space between the front surface 210a and the rear surface 210b.

In an embodiment, the front surface 210a may be formed by a front plate 211a of which at least a portion is substantially transparent. For example, the front plate 211a may include a polymer plate or a glass plate including at least one coating layer. In an embodiment, the rear surface 210b may be formed by a rear plate 211b that is substantially opaque.

For example, the rear plate 211b may be formed of coated or tinted glass, ceramic, polymer, metal (e.g., aluminum, stainless steel, or magnesium), or a combination thereof. The side surface 211c may be coupled to the front plate 211a and the rear plate 211b and may be formed by a side member 240 including metal and/or polymer. In an embodiment, the rear plate 211b and the side member 240 may be integrally and seamlessly formed. In an embodiment, the rear plate 211b and the side member 240 may be formed of substantially the same material (e.g., aluminum).

In an embodiment, the front plate 211a may include a plurality of first periphery areas 212a-1 that are rounded in a direction from at least a partial area of the front surface 210a toward the rear plate 211b and extend in one direction (e.g., the +/X-axis direction), a plurality of second periphery areas 212a-2 that are rounded in the direction from at least a partial area of the front surface 210a toward the rear plate 211b and extend in the other direction (e.g., the +/- Y-axis direction), and a plurality of third periphery areas 212a-3 that are rounded in the direction from at least a partial area of the front surface 210a toward the rear plate 211b and disposed between the plurality of first periphery areas 212a-1 and the plurality of second periphery areas 212a-2.

In an embodiment, the rear plate 211b may include a plurality of fourth periphery areas 212b-1 that are rounded in a direction from at least a partial area of the rear surface 210b toward the front plate 211a and extend in one direction (e.g., the +/X-axis direction), a plurality of fifth periphery areas 212b-2 that are rounded in the direction from at least a partial area of the rear surface 210b toward the front plate 211a and extend in the other direction (e.g., the +/- Y-axis direction), and a plurality of sixth periphery areas 212b-3 that are rounded in the direction from at least a partial area of the rear surface 210b toward the front plate 211a and disposed between the plurality of fourth periphery areas 212b-1 and the plurality of fifth periphery areas 212b-2.

In an embodiment, the side member 240 may surround at least a portion of the inner space between the front surface 210a and the rear surface 210b. The side member 240 may include a first support structure 241 disposed on at least a portion of the side surface 211c and a second support structure 242 connected to the first support structure 241 to form a space for disposing the components of the electronic device 201.

In an embodiment, the first support structure 241 may connect the periphery of the front plate 211a and the periphery of the rear plate 211b and surround the space between the first plate 211a and the second plate 211b, thereby forming the side surface 211c of the housing 210. In an embodiment, the second support structure 242 may be disposed inside (or in a body portion) of the electronic device 201. The second support structure 242 may be integrally formed with the first support structure 241 or may be formed separately from the first support structure 241 and connected to the first support structure 241. In an embodiment, the first support structure 241 and/or the second support structure 242 may be a component of the housing 210.

In an embodiment, PCB assemblies 251 and 252 may be disposed in the second support structure 242. For example, the second support structure 242 may be connected to the grounds of the PCB assemblies 251 and 252. In an embodiment, a display 261 may be disposed on one surface (e.g., a lower surface (a surface in the +Z-axis direction) of FIG. 3) of the second support structure 242, and the rear plate 211b may be disposed on the other surface (e.g., an upper surface (a surface in the -Z-axis direction) of FIG. 3) of the second support structure 242.

In an embodiment, at least a portion of the side member 240 may be formed of a conductive material. For example, the first support structure 241 may be formed of a metal and/or conductive polymer material. In an embodiment, like the first support structure 241, the second support structure 242 may be formed of a metal and/or conductive polymer material.

In an embodiment, the electronic device 201 may include the display 261 (e.g., the display module 160 of FIG. 1). In an embodiment, the display 261 may be positioned on the front surface 210a. In an embodiment, the display 261 may be exposed through at least a portion (e.g., the plurality of first periphery areas 212a-1, the plurality of second periphery areas 212a-2, and the plurality of third periphery areas 212a-3) of the front plate 211a. In an embodiment, the display 261 may have a shape that is substantially the same as the shape of an outer edge of the front plate 211a.

In an embodiment, the periphery of the display 261 may substantially coincide with the outer edge of the first plate 211a. Although not shown in the drawings, the display 261 according to various embodiments may include a touch sensing circuit (not shown), a pressure sensor (not shown) for sensing an intensity (pressure) of a touch, and/or a digitizer (not shown) for detecting a magnetic-type stylus pen (not shown).

In an embodiment, the display 261 may include a screen display area 261a that is visually exposed to display content through pixels or a plurality of cells. In an embodiment, the screen display area 261a may include a sensing area 261a-1 and/or a camera area 261a-2. In this case, the sensing area 261a-1 may overlap at least a partial area of the screen display area 261a. The sensing area 261a-1 may allow transmission of an input signal related to a sensor module 276 (e.g., the sensor module 176 of FIG. 1). The sensing area 261a-1 may display content, like the screen display area 261a that does not overlap the sensing area 261a-1.

For example, the sensing area 261a-1 may display the content while the sensor module 276 is not operating. The camera area 261a-2 may overlap at least a partial area of the screen display area 261a. The camera area 261a-2 may allow transmission of an optical signal related to first camera modules 280a and 280b (e.g., the camera module 180 of FIG. 1). The camera area 261a-2 may display content, like the screen display area 261a that does not overlap the camera area 261a-2. For example, the camera area 261a-2 may display the content while the camera modules 280a and 280b are not operating.

In an embodiment, the electronic device 201 may include the sensor module 276. The sensor module 276 may sense a signal applied to the electronic device 201. The sensor module 276 may be positioned, for example, on the front surface 210a of the electronic device 201. The sensor module 276 may form the sensing area 261a-1 in at least a portion of the screen display area 261a. The sensor module 276 may receive an input signal transmitted through the sensing area 261a-1 and generate an electrical signal based on the received input signal. For example, the input signal may have a designated physical quantity (e.g., heat, light, temperature, sound, pressure, or ultrasound). As another example, the input signal may include a signal related to biometric information of a user (e.g., a fingerprint, a voice, and the like of a user).

In an embodiment, the electronic device 201 may include the camera modules 280a and 280b (e.g., the camera module 180 of FIG. 1). In an embodiment, the camera modules 280a and 280b may include the first camera module 280a and the second camera module 280b and may further include a flash 280c in various embodiments.

In an embodiment, the first camera module 280a may be disposed to be visible from the outside through the front surface 210a of the housing 210, and the second camera module 280b and the flash 280c may be disposed to be visible from the outside through the rear surface 210b of the housing 210. In an embodiment, at least a portion of the first camera module 280a may be disposed in the housing 210 so as to be covered through the display 261. In an embodiment, the first camera module 280a may receive an optical signal transmitted through the camera area 261a-2. In an embodiment, the second camera module 280b may include a plurality of cameras (e.g., dual cameras, triple cameras, or quad cameras). In an embodiment, the flash 280c may include a light-emitting diode or a xenon lamp.

In an embodiment, the electronic device 201 may include at least one sound hole 270. The sound hole 270 may be an opening that communicates with the outside of the electronic device 201 and may transmit air and/or sound to the inside of the housing 210. In an embodiment, the sound hole 270 may be formed in one surface of the housing 210.

For example, the sound hole 270 communicating with a sound output module (e.g., the sound output module 155 of FIG. 1) may receive a sound from the audio module 170 positioned inside the electronic device 201, and output the sound to the outside of the electronic device 201. Alternatively, for example, the sound hole 270 communicating with an audio module (e.g., the audio module 170 of FIG. 1) may obtain a sound from the outside of the electronic device 201, and transmit the sound to the audio module 170 positioned inside the electronic device 201.

In an embodiment, the sound hole 270 may be positioned in at least one of a plurality of side surfaces 211c of the housing 210. For example, the housing 210 may include the plurality of side surfaces 211c extending from the front surface 210a to the rear surface 210b, and the plurality of side surfaces 211c may include a lower side surface 211c-1, an upper side surface 211c-2, a right side surface 211c-3, and a left side surface 211c-4. In various embodiments, the sound hole 270 may be formed in at least one of the lower side surface 211c-1 and the upper side surface 211c-2 among the plurality of side surfaces 211c of the electronic device 201.

In an embodiment, the sound hole 270 may be positioned in the rear surface 210b of the housing 210. For example, the rear plate 211b of the housing 210 may include a camera hole 275 for disposing the second camera module 280b and the flash 280c, and the housing 210 may include a camera decoration 273 for protecting the second camera module 280b and the flash 280c. The camera decoration 273 may be coupled to the rear plate 211b, disposed in the camera hole 275, and visually exposed to the outside of the housing 210. In various embodiments, the sound hole 270 may be formed in the camera decoration 273 of the electronic device 201.

In an embodiment, the sound hole 270 may be one or more holes formed in the side surface 211c of the housing 210, and the sound hole 270 may output a sound to the outside of the electronic device 201. Alternatively, the sound hole 270 may be a hole formed non-visually in the front surface 210a of the housing 210, and may output a sound to the outside of the electronic device 201. In this case, the sound hole 270 may be occluded by the display 261, rather than being visually exposed to the outside.

In an embodiment, the electronic device 201 may include an input module 250 (e.g., the input module 150 of FIG. 1). The input module 250 may receive a manipulation signal of a user. The input module 250 may include, for example, at least one key input device disposed to be exposed on the side surface 211c of the housing 210.

In an embodiment, the electronic device 201 may include a connecting terminal 278 (e.g., the connecting terminal 178 of FIG. 1). In an embodiment, the connecting terminal 278 may be disposed on an outer circumferential surface of the housing 210 and for example, may be disposed on the lower side surface 211c of the electronic device 201 as shown in FIG. 2A. Specifically, when the electronic device 201 is viewed in one direction (e.g., the +Y-axis direction of FIG. 2A), the connecting terminal 278 may be positioned at a central portion of the lower side surface 211c, and the sound hole 270 may be disposed in one direction (e.g., a rightward direction) with respect to the connecting terminal 278.

As shown in FIGS. 2A and 2B, the sound hole 270 and the connecting terminal 278 may be disposed in the side surface 211c of the housing 210 that forms the exterior of the electronic device 201, but in actual implementation, embodiments are not limited thereto, and at least a portion thereof may be disposed in the front surface 210a or the rear surface 210b of the housing 210 or may be disposed inside the housing 210. For example, although not shown in the drawings, the housing 210 in an embodiment may include a cover (not shown) for replacing a battery 289.

In an embodiment, the electronic device 201 may include the battery 289 (e.g., the battery 189 of FIG. 1) and PCB assemblies 251 and 252 including one or more PCBs.

In an embodiment, the PCB assemblies 251 and 252 may include PCBs spaced apart from each other. For example, the PCB assemblies 251 and 252 may include a first PCB 251 and a second PCB 252. The first PCB 251 in an embodiment may be a main PCB of the electronic device 201 accommodated in a first substrate slot 242a of the second support structure 242, and the second PCB 252 may be a sub-PCB of the electronic device accommodated in a second substrate slot 242b of the second support structure 242. In an embodiment, the battery 289 may be accommodated by a battery slot 245 of the second support structure 242 formed between the first substrate slot 242a and the second substrate slot 242b.

In an embodiment, a wireless communication circuit (e.g., the wireless communication module 192 of FIG. 1) may be disposed on the PCB assemblies 251 and 252. The wireless communication circuit may perform communication with, for example, an external device (e.g., the electronic device 104 of FIG. 1). The electronic device 201 may include an antenna (e.g., the antenna module 197 of FIG. 1), and the wireless communication circuit may be electrically connected to an antenna structure. In an embodiment, the wireless communication circuit may generate a signal to be transmitted through the antenna structure or detect a signal received through the antenna structure. In an embodiment, the PCB assemblies 251 and 252 may include grounds, and the grounds of the PCB assemblies 251 and 252 may function as a ground of the antenna structure implemented using the wireless communication circuit.

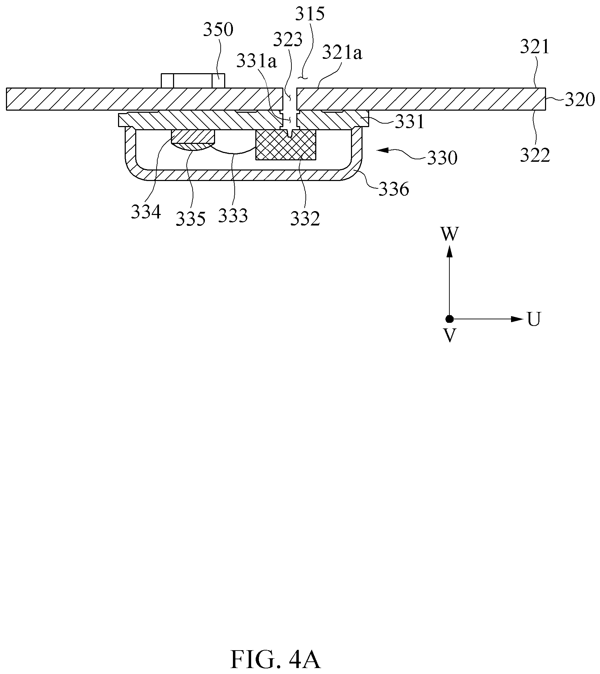

Hereinafter, based on the above description of the electronic device 201, various charging and discharging routes of the battery 289 and a structure to implement the same will be described. Hereinafter, in describing an electronic device (e.g., the electronic device 301 of FIG. 4A and following drawings), a description redundant to that of the electronic device 201 will be omitted, and some structures and configurations will be replaced, added, or omitted within a range that those skilled in the art can easily understand.

FIG. 4A is a cross-sectional view of a temperature sensor 350, a PCB 320, and a microphone element 330 according to an embodiment.

Referring to FIG. 4A, the microphone element 330 according to various embodiments may include at least a portion of a microphone board 331 or a transducer 332, and the temperature sensor 350 may be disposed opposite one surface of the microphone element 330.

Hereinafter, an exemplary structure of the microphone element 330 and the PCB 320 will be described based on a UVW coordinate system, which indicates that the structure and direction in which the microphone element 330 and the PCB 320 are disposed in the housing 210 of various embodiments of the electronic device 201 of FIGS. 2A, 2B, and 3 may be implemented in various manners, not limited to the XYZ coordinate directions.

In an embodiment, the microphone element 330 may be disposed on one surface of the PCB 320, and the PCB 320 may be disposed inside the housing 210. For example, the housing 210 may include a passage 315 communicating with a sound hole (e.g., the sound hole 270 of FIGS. 2A, 2B, and 3), and the PCB 320 may be disposed such that at least a partial area thereof may face the passage 315.

In an embodiment, the electronic device 201 may receive a sound from the outside or emit a sound to the outside through the sound hole 270 and the passage 315. The sound hole 270 and the passage 315 may be a flow path that communicates with the outside so that air may be introduced from or emitted to the outside of the electronic device 201.

In an embodiment, the PCB 320 may include a first surface 321 facing the passage 315 and a second surface 322 opposite the first surface 321. The first surface 321 may include an open area 321a, which is a partial area facing the passage 315, and the open area 321a may be an area directly or directly communicating with the outside through the passage 315 and the sound hole 270. In various embodiments, the PCB 320 may include a PCB hole 323 penetrating from the first surface 321 to the second surface 322, and the PCB hole 323 may be formed in the open area 321a.

In an embodiment, the microphone element 330 may be disposed on the second surface 322 of the PCB 320, and for example, the microphone element 330 may be disposed on the PCB hole 323 to be overlapping with the PCB hole 323 when the first surface 321 is viewed (e.g., viewed in the -W direction). The PCB hole 323 may be formed in the open area 321a, and may receive a sound from the outside through the passage 315 communicating with the outside, and the sound passing through the PCB hole 323 may be transmitted directly to the microphone element 330.

In an embodiment, the microphone element 330 may be implemented in various types and structures. For example, the microphone element 330 may be a micro-electromechanical systems (MEMS) microphone element, and may convert a sound received through the passage 315 into a signal.

In an embodiment, the microphone element 330 may include at least a portion of the microphone board 331, a cover member 336, or the transducer 332. Hereinafter, the structure and arrangement of the microphone element 330 of the electronic device 201 will be described based on a structure of the microphone element 330 according to an embodiment, which is, however, merely an example, and embodiments are not limited thereto in actual implementation.

In an embodiment, the microphone board 331 may be a board on which other components of the microphone element 330 are disposed. One surface of the microphone element 330 may be disposed to face the second surface 322 of the PCB 320, and the components (e.g., the transducer 332 or an ASIC chip 334) of the microphone element 330 and the cover member 336 for protecting the same may be disposed on the other surface thereof. In various embodiments, the microphone board 331 may include a microphone hole 331a communicating with the PCB hole 323.

In an embodiment, the transducer 332 may be disposed on the microphone board 331 to receive a sound through the microphone hole 331a. The transducer 332 may have a vibrating membrane formed therein, and may convert a sound received from the outside into an electrical signal through the vibrating membrane. For example, when the vibrating membrane vibrates due to sound pressure transmitted from the outside, the transducer 332 may generate an electrical signal based on the vibration.

In an embodiment, the microphone element 330 may be electrically connected to the ASIC chip 334 through a conducting wire 333. The ASIC chip 334 may be disposed on the microphone board 331 to amplify the electrical signal received from the transducer 332. The ASIC chip 334 may transmit the amplified signal to the PCB 320 and/or a processor (e.g., the processor 120 of FIG. 1). A top member 335 including epoxy or a silicon material may be formed on the ASIC chip 334, and the top member 335 may protect the ASIC chip 334 and the conducting wire 333.

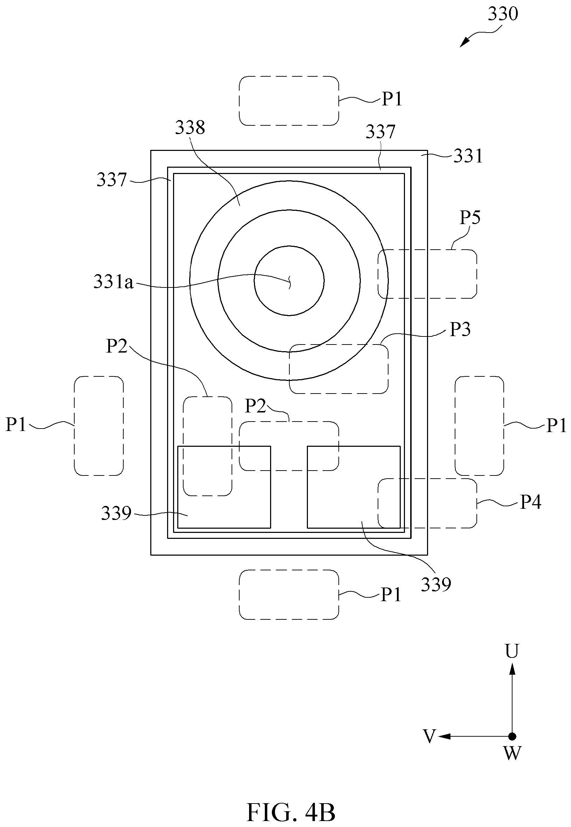

In an embodiment, the cover member 336 may protect the components disposed in the microphone element 330. The cover member 336 may be called a can and may include a metal material. The cover member 336 and the microphone board 331 may be sealed by a sealing area (e.g., the sealing area 337 of FIG. 4B) to be hermetic from the outside. Embodiments are not limited thereto, and the microphone element 330 may be in a structure in which an opening (not shown) is formed in the cover member 336 to receive a sound from the outside.

In an embodiment, the temperature sensor 350 may be disposed in the open area 321a of the first surface 321 of the PCB 320, for example, on a side of the PCB hole 323 in the open area 321a. The temperature sensor 350 may be disposed in the open area 321a and receive air from the outside of the housing 210 through the sound hole 270 and the passage 315.

In an embodiment, the temperature sensor 350 may have a variable factor, including a numerical value that changes in response to the temperature of air received through the passage 315. For example, the variable factor may be a resistance, and the temperature sensor 350 may be an element whose resistance value changes according to the surrounding temperature.

In an embodiment, when the resistance value of the temperature sensor 350 changes, the voltage of a voltage distribution circuit of a processor (e.g., the processor 120 of FIG. 1) or the PCB 320 may change, and the processor 120 may detect the voltage change and detect the temperature of air surrounding the temperature sensor 350 (or the temperature of air outside the housing 210) based on the same. The processor 120 may detect the temperature based on a change in the numerical value of the variable factor of the temperature sensor 350 by referring to a temperature table stored in memory (e.g., the memory 130 of FIG. 1). However, this is an example of one of the various temperature detection methods of the temperature sensor 350 and the processor 120, and in actual implementation, the temperature may be detected in various manners.

In various embodiments of the disclosure, the temperature sensor 350 may be disposed in an open area (e.g., the open area 321a of FIG. 4A) of the first surface 321 where the PCB 320 and the passage 315 face each other, and the microphone element 330 may be disposed on the second surface 322 opposite the first surface 321, and this may bring various advantages in the performance of the temperature sensor 350 and/or the design of the electronic device 201.

For example, the temperature sensor 350 may be disposed relatively adjacent to the passage 315 and spaced apart from the other elements. Alternatively, the microphone element 330 may be an element having relatively small heat emission compared to the other elements of the electronic device 201, and may reduce error factors of the temperature sensor 350.

For example, the electronic device 201 may dispose the temperature sensor 350 to measure the external temperature on the sound hole 270 and the passage 315 communicating with the microphone element 330, without forming an additional structure for disposing the temperature sensor 350, which may bring an advantage in the structural design of the electronic device 201.

FIG. 4B is a diagram illustrating various arrangement designs of the temperature sensor 350 disposed on the microphone element 330 according to an embodiment.

Referring to FIG. 4B, the microphone element 330 in various embodiments may include at least a portion of a contact area 338, the sealing area 337, and a terminal area 339, and the temperature sensor 350 may be disposed in various positions so that at least a partial area thereof may be overlapping with the microphone element 330 or the entire area thereof may be non-overlapping with the microphone element 330.

In an embodiment, the contact area 338 may connect the transducer 332 and the microphone board 331, and the sealing area 337 may connect and/or seal the microphone board 331 and the cover member 336. In various embodiments, the terminal area 339 may electrically connect the microphone element 330 and the PCB 320.

In an embodiment, the temperature sensor 350 may be disposed in at least one of a plurality of positions P1, P2, P3, P4, and P5, for example, in any one of the first position P1 or the second position P2, to be overlapping or non-overlapping with the microphone element 330, on one surface of the microphone board 331 (e.g., the first surface 321 of the PCB 320 of FIG. 4A), based on a state in which one surface (or the first surface 321 of FIG. 4A) of the microphone board 331 is viewed.

In an embodiment, the temperature sensor 350 may be disposed on the PCB 320 to be non-overlapping with the microphone element 330 or the sealing area 337, based on the state in which the first surface 321 is viewed (e.g., viewed in the -W direction).

For example, the temperature sensor 350 may be disposed in one of a plurality of first positions P1 shown in FIG. 4B. The temperature sensor 350 may be disposed in an area outside the microphone board 331 or in an area outside the sealing area 337, of the microphone element 330. In various embodiments, the plurality of first positions P1 may be applied to a situation where the space of the passage 315 and the open area 321a is relatively wide, greatly increasing the accuracy of the temperature sensor 350.

In an embodiment, when the temperature sensor 350 and the microphone element 330 are non-overlapping, the effect of heat and/or vibration generated as the microphone element 330 is driven may be reduced. In various embodiments, the temperature sensor 350 in one of the plurality of first positions P1 may reduce errors in the detection result obtained by detecting the external temperature and increase the accuracy of the detection result.

In an embodiment, the temperature sensor 350 may be disposed on the PCB 320 while at least a partial area thereof is overlapping with the microphone element 330, based on one surface (or the first surface 321 of FIG. 4A) of the microphone board 331. For example, the temperature sensor 350 may be disposed in one of a plurality of second positions P2 shown in FIG. 4B.

According to the present invention, the temperature sensor 350 is disposed on the PCB 320 to be non-overlapping with the contact area 338 and may be non-overlapping with the sealing area 337 of the microphone element 330, based on a state in which the first surface 321 is viewed, like the plurality of second positions P2. In various embodiments, when the temperature sensor 350 and the microphone element 330 are overlapping in at least a partial area, the space to be secured for the temperature sensor 350 may be reduced, which may be advantageous to the structural design of the electronic device 201.

In an embodiment, the plurality of second positions P2 may be advantageous in arranging the temperature sensor 350 when the space of the passage 315 and the open area 321a is limited. The plurality of second positions P2 may reduce deformation and/or processing of the passage 315 and the open area 321a for arranging the temperature sensor 350, and increase space efficiency.

For example, it may be required to change the arrangement of other components or deform the sound space to dispose the temperature sensor 350. Compared to the other positions, the plurality of second positions P2 may require a change of the arrangement of the other components or a deformation of the sound space relatively little, and a correction algorithm for the detection result of the temperature sensor 350 may be simplified or omitted.

In another embodiment, if an element emitting energy is disposed around the temperature sensor 350, an error may occur in the detection result of the temperature sensor 350. To prevent the foregoing, in various embodiments of the disclosure, executing a separate temperature correction algorithm or disposing the temperature sensor 350 in a position where no or fewer elements are disposed nearby may improve the efficiency and accuracy of detecting the external temperature.

In other examples, the third position P3, the fourth position P4, and the fifth position P5 may be overlapping with at least one of the contact area 338 and the sealing area 337, based on a state in which the first surface 321 is viewed.

For example, in the third position P3 and the fifth position P5, the temperature sensor 350 may face the transducer 332 of the microphone element 330 in at least a partial area, or in the fourth position P4 and the fifth position P5, the temperature sensor 350 may face the cover member 336 in at least a partial area.

In various embodiments, the transducer 332 and the cover member 336 may increase in temperature or be heated for various reasons, which may cause errors in the detection result of the temperature sensor 350.

For example, the microphone board 331 and the PCB 320 may be heated as the transducer 332 is driven. Alternatively, the cover member 336 may be heated by the other components of the electronic device 201 or the microphone element 330. For example, unlike the inside of the microphone element 330 which substantially communicates with the outside air, the cover member 336 including a metal can may be relatively highly likely to be heated.

For example, in the case of the third position P3, a change of the arrangement design of other components may be required to arrange the temperature sensor 350, or various errors such as an error in the arrangement of the temperature sensor 350 and other components and invasion of soldering may cause contamination of the microphone element 330 and the temperature sensor 350 or an acoustic distortion of the microphone element 330.

For example, in the case of the fourth position P4 and the fifth position P5, the temperature sensor 350 may be overlapping with the cover member 336 of the microphone element 330, and vibration or deformation of the other components of the electronic device 201 or the microphone element 330 may cause damage to the temperature sensor 350.

In various embodiments of the present disclosure, the temperature sensor 350 may be disposed identically or similarly to any one of the plurality of second positions P2, or the temperature sensor 350 may be disposed differently from the third position P3, the fourth position P4, and the fifth position P5. Even when the temperature sensor 350 and the microphone element 330 are overlapping, it is possible to reduce and/or minimize the errors caused by the microphone element 330, prevent contamination or acoustic distortion of the microphone element 330, prevent damage to the temperature sensor 350, or improve the space efficiency of the electronic device 201.

Hereinafter, based on the structure and arrangement of the microphone element 330, the PCB 320, and the temperature sensor 350 described with reference to FIGS. 4A and 4B, various structures in which the temperature sensor 350 is disposed inside the housing 210 of the electronic device 201 of FIGS. 2A, 2B, and 3 will be described.

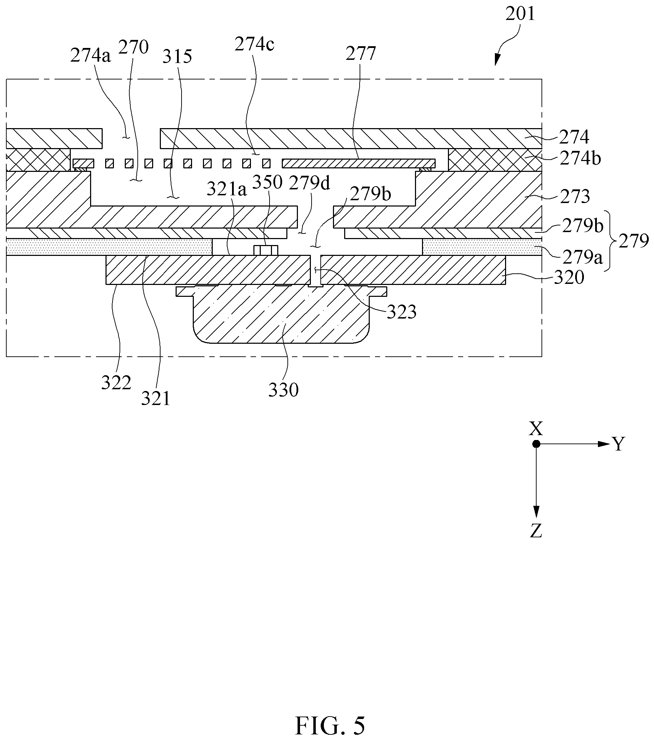

FIG. 5 is a cross-sectional view of the inside of the electronic device 201 according to an embodiment. Specifically, FIG. 5 is a cross-sectional view in a state in which the inside of the electronic device 201 is viewed based on line C-C' of FIG. 2B.

Referring to FIG. 5, the sound hole 270 in various embodiments may be formed in the camera decoration 273.

In an embodiment, the temperature sensor 350 may be disposed inside or adjacent to the camera decoration 273 of a housing (e.g., the housing 210 of FIGS. 2A, 2B, and 3). For example, the PCB 320 may be disposed so that the first surface 321 may face the camera decoration 273 and the second surface 322 may face a front plate (e.g., the front plate 211a of FIGS. 2A, 2B, and 3), and the temperature sensor 350 may be disposed on the first surface 321 of the PCB 320.

In various embodiments, a partial area of the PCB 320, for example, the area where the temperature sensor 350 and the microphone element 330 are disposed or the open area 321a may be positioned inside the camera hole 275 in the rear plate 211b of the housing 210, wherein the first surface 321 including the open area 321a of the PCB 320 may face the camera decoration 273, and the second surface 322 of the PCB 320 may face the front plate 211a.

In an embodiment, the sound hole 270 may be formed in the camera decoration 273, and the passage 315 may be formed from the camera decoration 273 toward the inside of the housing 210. For example, the sound hole 270 in an embodiment may be a rear sound hole 270 formed in the camera decoration 273 positioned on the rear surface of the housing 210 of the electronic device 201.

In various embodiments, the sound hole 270 and the microphone element 330 in the rear surface may be disposed adjacent to a camera module (e.g., the second camera module 280b of FIG. 2B) on the rear surface, and may collect a sound for video recording of the camera module 280b or be used for noise canceling by recognizing an external sound during a voice call of the electronic device 201.

In an embodiment, based on the camera decoration 273, the PCB 320 may be disposed in an inward direction of the electronic device 201, and a camera window 274 may be disposed in an outward direction of the electronic device 201. The camera window 274 may include a camera window hole 274a that communicates with the outside of the housing 210 so as to communicate with the sound hole 270 of the camera decoration 273.

In an embodiment, a window tape 274b may be disposed between the camera window 274 and the camera decoration 273. The window tape 274b may adhere the camera window 274 to the camera decoration 273. The window tape 274b may include a window tape hole 274c that is open to communicate with the camera window hole 274a and the sound hole 270, and a rear mesh 277 may be disposed in the window tape hole 274c.

In an embodiment, the rear mesh 277 may prevent water or a foreign substance from entering through the camera window hole 274a or the window tape hole 274c. The rear mesh 277 may at least partially include a mesh net of a metal material, and may be adhered to the camera decoration 273.

In an embodiment, the PCB 320 and the camera decoration 273 may be connected through a sealing member 279. The sealing member 279 may connect the first surface 321 of the PCB 320 and the camera decoration 273. In various embodiments, the sealing member 279 may have a single-layer structure, or may have a multi-layer structure. For example, the sealing member 279 may include a first sealing layer 279a and a second sealing layer 279c, and the first sealing layer 279a may be disposed on the first surface 321 of the PCB 320, and the second sealing layer 279c may be disposed between the first sealing layer 279a and the camera decoration 273.

In an embodiment, the sealing member 279 may include at least one layer hole 279b and 279d to surround at least a partial area of the open area 321a. For example, the first sealing layer 279a may include a first layer hole 279b, and the second sealing layer 279c may include a second layer hole 279d.

In an embodiment, the first layer hole 279b may surround the PCB hole 323 and the temperature sensor 350, or the open area 321a of the first surface 321. The second layer hole 279d may communicate with the first layer hole 279b and the sound hole 270.

In an embodiment, in a state in which the first surface 321 is viewed (e.g., viewed in the +Z direction), the first layer hole 279b and the size of the second layer hole 279d may differ in size. For example, the diameter of the first layer hole 279b may be larger than the diameter of the second layer hole 279d.

In various embodiments, a space communicating with the passage 315 and the outside may be formed between the open area 321a of the first surface 321 of the PCB 320 and the second sealing layer 279c, and the temperature sensor 350 may be disposed between the open area 321a of the first surface 321 of the PCB 320 and the second sealing layer 279c.

In an embodiment, the electronic device 201 may form a space to dispose the temperature sensor 350, by forming the passage 315 from the sound hole 270 formed in the camera decoration 273 to the PCB 320 and forming the first layer hole 279b of the first sealing layer 279a to be greater than the second layer hole 279d of the second sealing layer 279c.

In an embodiment, the passage 315 may be formed by successively penetrating through at least a portion of the camera window hole 274a, the window tape hole 274c, the rear mesh 277, the sound hole 270 of the camera decoration 273, or the plurality of layer holes 279b and 279d. In various embodiments, the PCB 320 may be a main PCB (e.g., the first PCB 251 of FIG. 3) disposed on the top end of the electronic device 201, or may be a separate PCB that is different from the main PCB.

In an embodiment of the present disclosure, the multi-layer structure of the sealing member 279 may easily form the space to dispose the temperature sensor 350. The electronic device 201 does not need to provide a separate space for the temperature sensor 350 by utilizing the sound hole 270 and the camera decoration 273 in the rear surface to measure the external temperature, and thus, the electronic device 201 may have improved space efficiency in terms of the internal design.

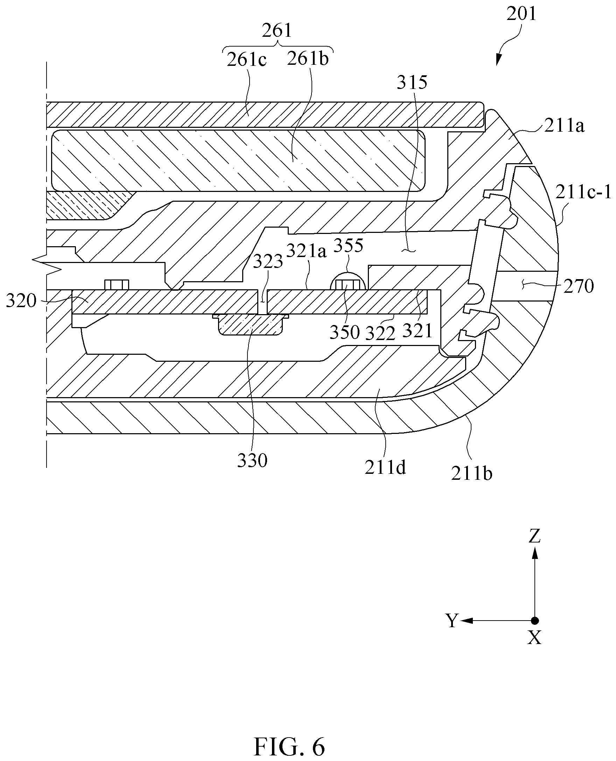

FIG. 6 is a cross-sectional view of the inside of the electronic device 201 according to an embodiment of the disclosure. Specifically, FIG. 6 is a cross-sectional view in a state in which the inside of the electronic device 201 is viewed based on line A-A' of FIG. 2A.

Referring to FIG. 6, the sound hole 270 in various embodiments may be formed in a plurality of side surfaces (e.g., the plurality of side surfaces 211c of FIGS. 2A and 2B) of a housing (e.g., the housing 210 of FIGS. 2A, 2B, and 3), and may be formed, for example, in a lower side surface (e.g., the lower side surface 211c-1 of FIGS. 2A and 2B) of the plurality of side surfaces 211c.

In an embodiment, the PCB 320 and the temperature sensor 350 may be disposed between the front plate 211a and the rear plate 211b. For example, the PCB 320 may be disposed so that the first surface 321 may face the front plate 211a and the second surface 322 may face the rear plate 211b.

In various embodiments, a partial area of the PCB 320, for example, the area in which the temperature sensor 350 and the microphone element 330 are disposed or the open area 321a may be positioned between the front plate 211a and the rear plate 211b.

In an embodiment, the housing 210 may include an inner housing 211d positioned between the rear plate 211b and the front plate 211a. The inner housing 211d may support a component (e.g., the PCB 320) disposed between the rear plate 211b and the front plate 211a.

In an embodiment, the first surface 321 including the open area 321a of the PCB 320 may face the front plate 211a and/or the display 261, and the second surface 322 of the PCB 320 may face the rear plate 211b and/or the inner housing 211d. A space that is open to dispose the microphone element 330 may be formed between the inner housing 211d and the second surface 322 of the PCB 320.

In an embodiment, the display 261 may be disposed in one direction (e.g., the +Z direction) of the front plate 211a. The display 261 may include a display module 261b (e.g., the display module 160 of FIG. 1) and a display window 261c for protecting the display module 261b.

In an embodiment, the sound hole 270 may be formed in the lower side surface 211c-1 of the housing 210, for example, in the rear plate 211b, and the passage 315 may penetrate through the front plate 211a from the rear plate 211b toward the inside of the housing 210. For example, the sound hole 270 in an embodiment may be a lower sound hole 270 formed in the lower side surface 211c-1 of the housing 210 of the electronic device 201.

In an embodiment, the passage 315 may be formed through the front plate 211a and extend from the sound hole 270 to the first surface 321 of the PCB 320. The front plate 211a may be formed to support or contact a partial area of the PCB 320. The temperature sensor 350 may be disposed in the open area 321a, which is an area, of the first surface 321 of the PCB 320, not contacting the front plate 211a.

In an embodiment, the PCB 320 may be a sub-PCB (e.g., the second PCB 252 of FIG. 3) positioned relatively more adjacent to the lower end of the electronic device 201, for example, the lower side surface 211c-1, than the upper side surface 211c-2 of the housing 210. In various embodiments, the sound hole 270 and the microphone element 330 in the lower side surface 211c-1 of the housing 210 may collect a sound for a voice call of the electronic device 201 or a gesture of a user.

In an embodiment, the electronic device 201 may include a cap member 355 covering the temperature sensor 350. Since water or a foreign substance on the temperature sensor 350 may cause errors in the detection result of the temperature sensor 350, the cap member 355 may surround the outer surface of the temperature sensor 350 to prevent water or a foreign substance from being in direct contact with the temperature sensor 350. In various embodiments, the cap member 355 may include a material with high thermal conductivity or elasticity, for example, a resin material.

In an embodiment of the disclosure, the electronic device 201 may easily form a space to dispose the temperature sensor 350 from the sound hole 270 and the passage 315 positioned in the lower side surface 211c-1. The passage 315 may be formed from the sound hole 270 formed in the side surface 211c along the front plate 211a to the PCB 320, and the temperature sensor 350 may be disposed in the space open between the front plate 211a and the PCB 320. The electronic device 201 does not need to provide a separate space for the temperature sensor 350 by utilizing the sound hole 270 and the passage 315 in the lower side surface 211c-1 to measure the external temperature, and thus, the electronic device 201 may have improved space efficiency in terms of the internal design.

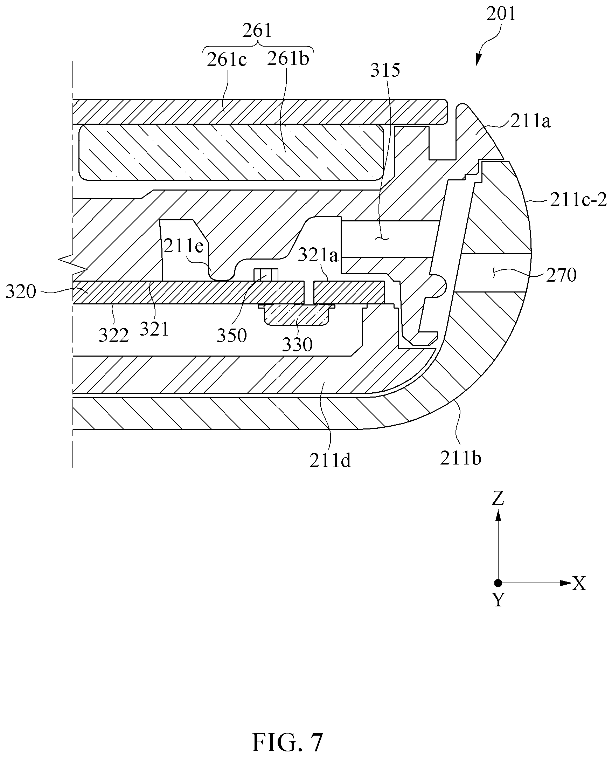

FIG. 7 is a cross-sectional view of the inside of the electronic device 201 according to an embodiment. Specifically, FIG. 7 is a cross-sectional view in a state in which the inside of the electronic device 201 is viewed based on line B-B' of FIG. 2A.

Referring to FIG. 7, the sound hole 270 in various embodiments may be formed in a plurality of side surfaces (e.g., the plurality of side surfaces 211c of FIGS. 2A and 2B) of a housing (e.g., the housing 210 of FIGS. 2A, 2B, and 3), and may be formed in an upper side surface (e.g., the upper side surface 211c-2 of FIGS. 2A and 2B) of the plurality of side surfaces 211c. In describing FIG. 7, for ease of description, a description redundant to or clear from the above description will be omitted.

In an embodiment, the PCB 320 and the temperature sensor 350 may be disposed between the front plate 211a and the rear plate 211b, and the PCB 320 may be disposed so that the first surface 321 may face the front plate 211a and the second surface 322 may face the rear plate 211b and/or the inner housing 211d. A partial area of the PCB 320, for example, the area in which the temperature sensor 350 and the microphone element 330 are disposed or the open area 321a may be positioned between the front plate 211a and the rear plate 211b.

In an embodiment, the first surface 321 including the open area 321a of the PCB 320 may face the front plate 211a and/or the display 261, and the second surface 322 of the PCB 320 may face the rear plate 211b and/or the inner housing 211d. A space that is open to dispose the microphone element 330 may be formed between the inner housing 211d and the PCB 320.

In an embodiment, the sound hole 270 may be formed in the upper side surface 211c-2 of the housing 210, for example, in the rear plate 211b, and the passage 315 may penetrate through the front plate 211a from the rear plate 211b toward the inside of the housing 210. For example, the sound hole 270 in an embodiment may be an upper sound hole 270 formed in the upper side surface 211c-2 of the housing 210 of the electronic device 201.

In an embodiment, the passage 315 may be formed through the front plate 211a and extend from the sound hole 270 to the first surface 321 of the PCB 320. The front plate 211a may be formed to support or contact a partial area of the PCB 320. The temperature sensor 350 may be disposed in the open area 321a, which is an area, of the first surface 321 of the PCB 320, not contacting the front plate 211a.

In an embodiment, the front plate 211a may include a rib area 211e protruding toward the first surface 321 to be in contact with the first surface 321 and supporting the PCB 320. The rib area 211e may protrude in a direction (e.g., the -Z direction) from the front plate 211a toward the rear plate 211b, and an end of the rib area 211e may be in contact with the PCB 320.

In an embodiment, the rib area 211e may be in contact with the first surface 321 at a position farther from the PCB hole 323 than the temperature sensor 350. For example, in the structure of the passage 315, the sound hole 270 may form one end portion of the passage 315, and the rib area 211e may form the other end portion of the passage 315 opposite the one end portion. The open area 321a may be formed between the front plate 211a and the first surface 321 of the PCB 320 through the rib area 211e.

In an embodiment, the rib area 211e may be in contact with the first surface 321 so as to be non-overlapping with the microphone element 330, based on a state in which the first surface 321 is viewed. As the rib area 211e is non-overlapping with the microphone element 330, a space to dispose the temperature sensor 350 may be provided. Alternatively, as the rib area 211e is non-overlapping with the microphone element 330, correction of the detection result of the temperature sensor 350 by the microphone element 330 may be more easily and accurately performed.

In an embodiment, the PCB 320 may be a main PCB (e.g., the first PCB 251 of FIG. 3) positioned relatively more adjacent to the upper end of the electronic device 201, for example, the upper side surface 211c-2, than the lower side surface 211c-1 of the housing 210. In various embodiments, the sound hole 270 and the microphone element 330 in the upper side surface 211c-2 of the housing 210 may collect a sound for a voice call of the electronic device 201 or a gesture of a user.

In an embodiment of the present disclosure, the electronic device 201 may easily form a space to dispose the temperature sensor 350 from the sound hole 270 and the passage 315 positioned in the upper side surface 211c-2. The passage 315 may be formed from the sound hole 270 formed in the rear plate 211b along the front plate 211a to the PCB 320, and the temperature sensor 350 may be disposed in the space open between the front plate 211a and the PCB 320. The electronic device 201 does not need to provide a separate space for the temperature sensor 350 by utilizing the sound hole 270 and the passage 315 in the upper side surface 211c-2 to measure the external temperature, and thus, the electronic device 201 may have improved space efficiency in terms of the internal design.

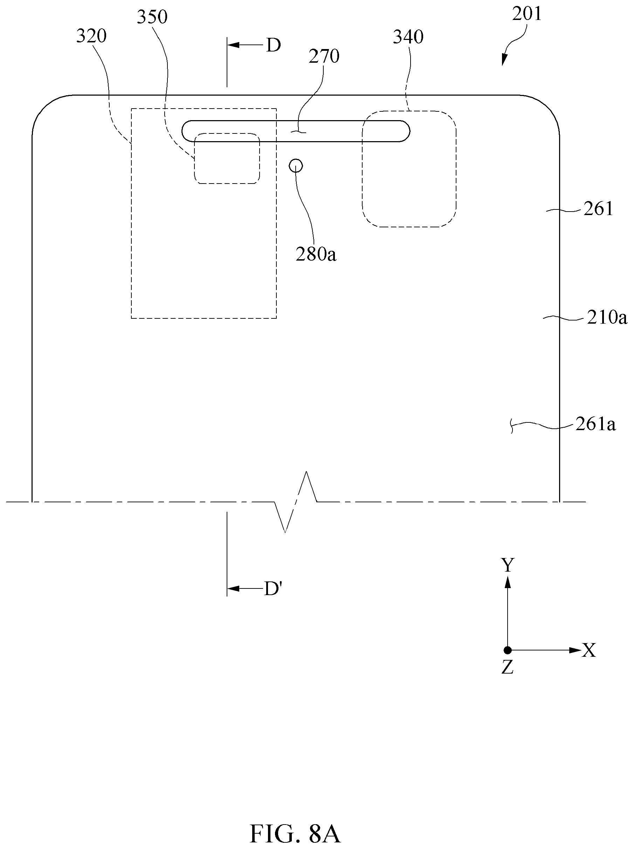

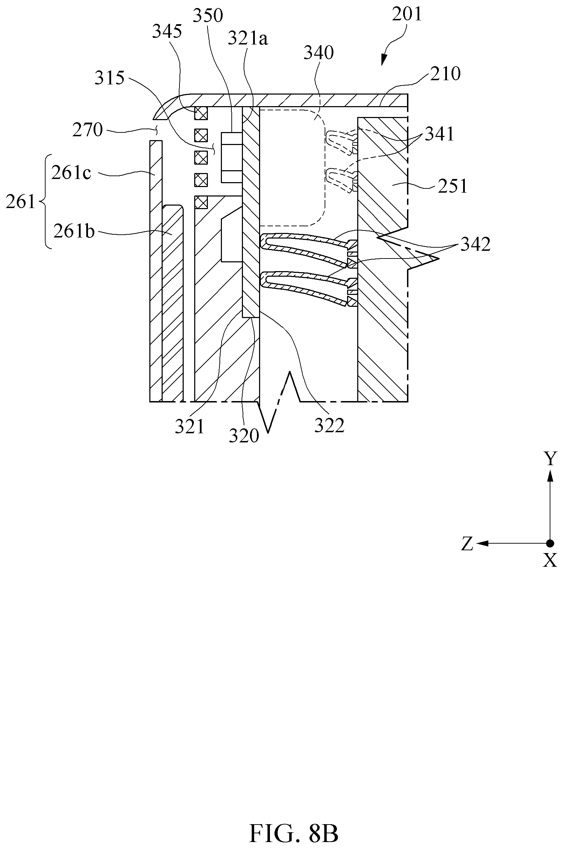

FIG. 8A is a front view of the electronic device 201 according to an embodiment, and FIG. 8B is a cross-sectional side view of the electronic device 201 according to an embodiment. Specifically, FIG. 8A is a front view when a partial area of the screen display area 261a of the electronic device 201 is viewed, and FIG. 8B is a cross-sectional view in a state in which the inside of the electronic device 201 is viewed based on line D-D' of FIG. 8A.

Referring to FIGS. 8A and 8B, the sound hole 270 in various embodiments may be formed in the front surface 210a of the housing 210.

In an embodiment, the PCB 320 and the temperature sensor 350 may be disposed between the display 261 and the front plate 211a of the housing 210, and the PCB 320 may be disposed so that the first surface 321 may face the display 261 and the second surface 322 may face the front plate 211a.

In an embodiment, the sound hole 270 may be formed in the front surface 210a of the housing 210, for example, between the display 261 and the front plate 211a. For example, the sound hole 270 may be formed in an upper portion of the first camera module 280a, in the screen display area 261a. The passage 315 may be formed in the front plate 211a and communicate with the outside through the sound hole 270 in the front surface 210a.

In an embodiment, the first surface 321 of the PCB 320 may include the open area 321a facing the passage 315, and the temperature sensor 350 for detecting the temperature of air received from the outside of the housing 210 through the passage 315 may be disposed in the open area 321a. In an embodiment, at least a partial area of the temperature sensor 350 may be visually exposed to the outside of the electronic device 201 through the sound hole 270, or the temperature sensor 350 may communicate with the outside while not being visually exposed to the outside.

In an embodiment, a receiver 340 may be disposed so that at least a partial area thereof may face the passage 315 and output a sound through the passage 315. The receiver 340 may be positioned between the second surface 322 of the PCB 320 and the first PCB 251, which is the main PCB positioned inside the housing 210. In an embodiment, based on a state in which the front surface 210a is viewed, the receiver 340 and the PCB 320 may be disposed to be non-overlapping with each other. Since the receiver 340 outputs a sound in a direction that the front surface 210a faces, a degradation in the quality of sound by the PCB 320 may be prevented as the PCB 320 and the receiver 340 are non-overlapping.

In an embodiment, the electronic device 201 may include a mesh member 345 disposed in front of the temperature sensor 350 and the receiver 340. The mesh member 345 may be disposed between the sound hole 270, and the temperature sensor 350 and the receiver 340, and prevent a foreign substance from entering from the outside of the sound hole 270. The mesh member 345 may at least partially include a mesh net of a metal material, and may be supported by the front plate 211a.

In an embodiment, the PCB 320 may be a separate PCB 320 that is different from the PCB assemblies 251 and 252 including the first PCB 251. In an embodiment, the receiver 340 may be supported against the first PCB 251 by the first support member 341, and the PCB 320 may be supported against the first PCB 251 by the second support member 342.

In an embodiment, the electronic device 201 may include a cap member 355 covering the temperature sensor 350. Since water or a foreign substance on the temperature sensor 350 may cause errors in the detection result of the temperature sensor 350, the cap member 355 may surround the outer surface of the temperature sensor 350 to prevent water or a foreign substance from being in direct contact with the temperature sensor 350. In various embodiments, the cap member 355 may include a material with high thermal conductivity or elasticity, for example, a resin material.

In an embodiment, a processor (e.g., the processor 120 of FIG. 1) of the electronic device 201 may correct the detection result of the temperature sensor 350. The processor 120 may control the drive of the receiver 340 or obtain information about the driving state of the receiver 340. The processor 120 may receive the detection result from the temperature sensor 350, and adjust the detection result of the temperature sensor 350 through a correction algorithm for correcting the detection result of the temperature sensor 350 based on an operation of the receiver 340.

For example, the processor 120 may correct the external temperature according to the correction algorithm based on whether the receiver 340 is driven within a predetermined time from the detection point in time of the temperature sensor 350. Alternatively, the processor 120 may not use the detection result of the temperature sensor 350 or may adjust a result of detecting the external temperature expected according to the correction algorithm of the temperature sensor 350, based on the length of the driving time of the receiver.

In various embodiments, the receiver 340 may output a sound by the processor 120 and consume power to vibrate a diaphragm. As the receiver 340 is driven, the passage 315 may be internally heated, which may affect the temperature detection result of the temperature sensor 350.

In an embodiment, the processor 120 may determine whether the passage 315 is internally overheated in consideration of the driving point in time and the length of the driving time of the receiver 340, and may not use the detection result of the temperature sensor 350 or may execute the correction algorithm on the detection result, based on the information about the drive of the receiver 340. The processor 120 may adjust an error in the detection result of the temperature sensor 350 caused by the drive of the receiver 340 through the correction algorithm.

In an embodiment of the present disclosure, the electronic device 201 may easily form a space to dispose the temperature sensor 350 from the sound hole 270 and the passage 315 positioned in the front surface 210a. The passage 315 may be formed from the sound hole 270 formed between the front plate 211a and the display along the front plate 211a to the PCB 320, and the temperature sensor 350 may be disposed in the space open between the front plate 211a and the PCB 320. The electronic device 201 does not need to provide a separate space for the temperature sensor 350 by utilizing the sound hole 270 and the passage 315 in the front surface 210a to measure the external temperature, and thus, the electronic device 201 may have improved space efficiency in terms of the internal design.

Although not shown in the drawings, in various embodiments of the present disclosure, the sound hole 270 communicating with the temperature sensor 350 may be replaced with an opening formed in a structure in which a volume key or a sound key of the electronic device 201 is drivably disposed, or may be replaced with various other configurations such as a SIM ejector space.

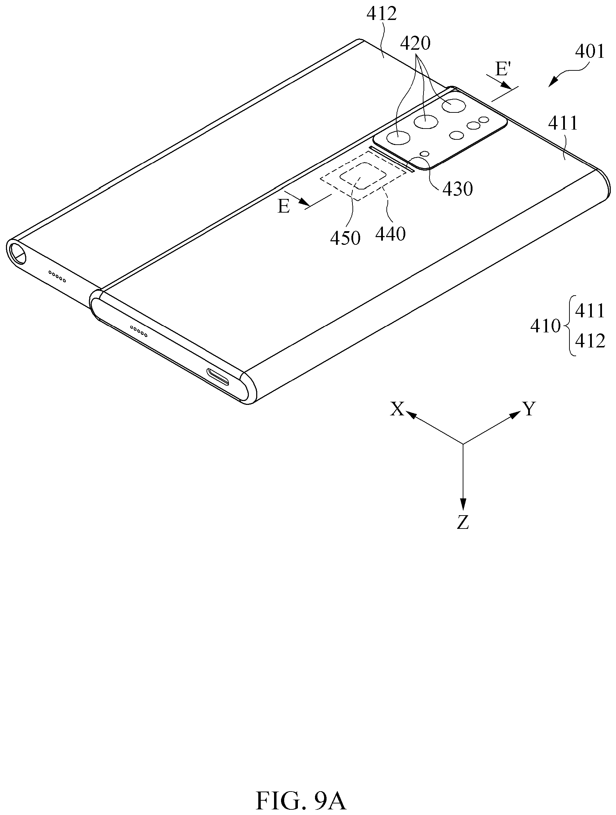

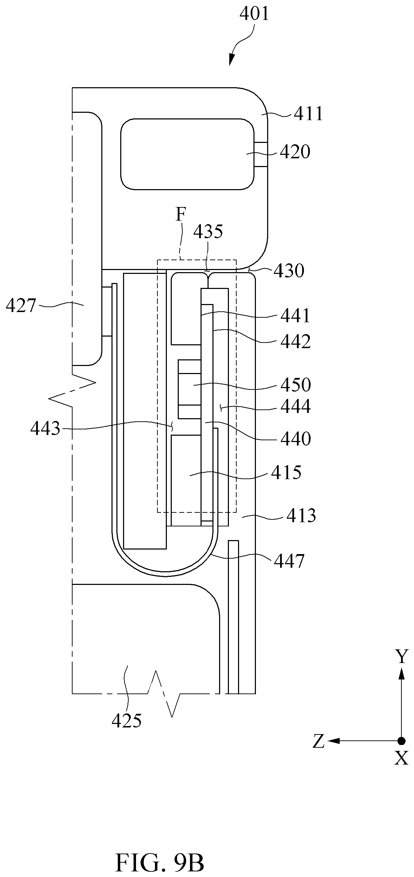

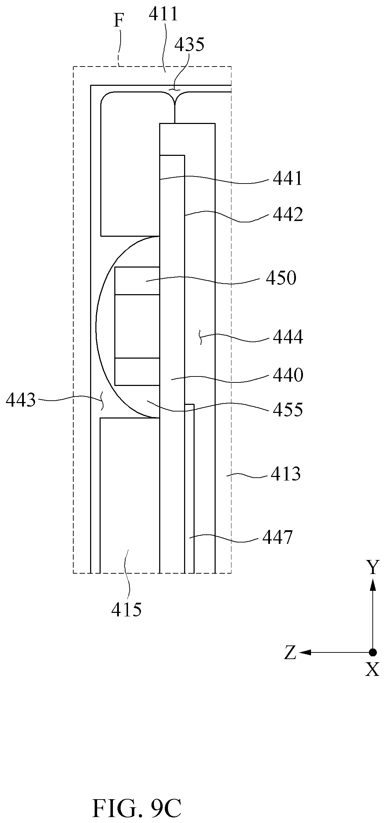

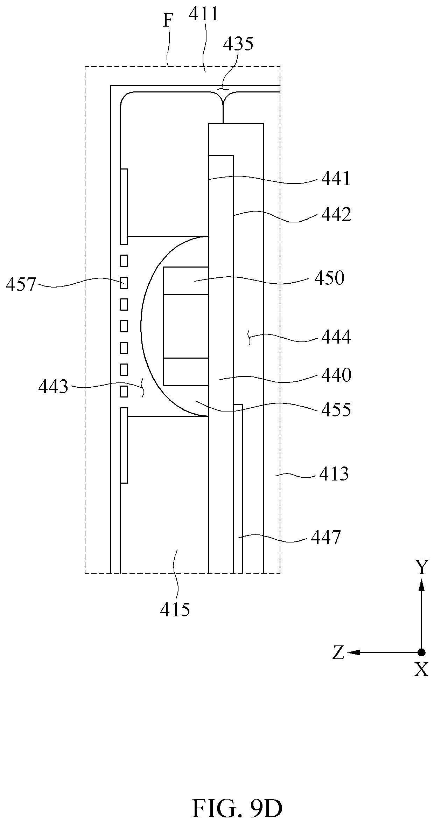

FIG. 9A is a rear perspective view of an electronic device 401 according to an embodiment, and FIGS. 9B, 9C, and 9D are cross-sectional side views of a partial area of the electronic device 401 according to an embodiment. Specifically, FIG. 9B is a cross-sectional view in a state in which the inside of the electronic device 401 is viewed based on line E-E' of FIG. 9A, and FIGS. 9C and 9D are enlarged views of an area F of FIG. 9B.

Referring to FIGS. 9A, 9B, 9C, and 9D, the electronic device 401 in various embodiments (e.g., the electronic device 101 of FIG. 1 or the electronic device 201 of FIGS. 2A, 2B, 3, 4A, 4B, 5 to 7, 8A, and 8B) may be a slidable electronic device 401.

In an embodiment, the electronic device 401 may include a camera module 420 (e.g., the camera module 180 of FIG. 1 or the second camera module 280b of FIG. 2B), a battery 425 (e.g., the battery 189 of FIG. 1 or the battery 289 of FIG. 3), a first PCB 427 (e.g., the first PCB 251 of FIG. 3), and a housing assembly 410 (e.g., the housing 210 of FIGS. 2A, 2B, and 3) accommodating those components and forming the exterior of the electronic device 401.

In an embodiment, the housing assembly 410 may include a first housing 411 and a second housing 412, and the electronic device 401 may be a slidable electronic device 401 that is relatively movable with respect to the first housing 411 and the second housing 412. The electronic device 401 may include a sliding driver (not shown) for slidably driving the first housing 411 and/or the second housing 412, and a hinge unit (not shown) for movably supporting the first housing 411 and the second housing 412.

In an embodiment, the camera module 420 may be disposed on the rear surface of the first housing 411, and a first opening 430 may be formed adjacent to the camera module 420. The first opening 430 may communicate with the passage 435 communicating with the inside of the first housing 411.

In various embodiments, the first opening 430 may be a sound hole (e.g., the sound hole 270 of FIGS. 2A, 2B, and 3), and a sound may pass through the passage 435. Embodiments are not limited thereto, and the passage 435 may be a space to dispose other components of the electronic device 401, such as the sliding driver (not shown) or the hinge unit (not shown), and the first opening 430 may be a hole communicating with the passage 435.

In an embodiment, the first housing 411 may include an inner rear member 415 and an outer rear member 413, and a sub-PCB 440 may be disposed inside the passage 435 and supported by the inner rear member 415 and /or the outer rear member 413. The inner rear member 415 may include a second opening 443 communicating with the passage 435, and the outer rear member 413 may include a third opening 444 in which the sub-PCB 440 is disposed. The sub-PCB 440 may be disposed so that a first surface 441 may face the second opening 443 and a second surface 442, which is opposite the first surface 441, may face the third opening 444.

In an embodiment, a temperature sensor 450 may be disposed in the second opening 443. The temperature sensor 450 may detect the temperature of air flowing in from the outside through the first opening 430 and the passage 435. The temperature sensor 450 may transmit a detection result to the sub-PCB 440, and the sub-PCB 440 may transmit the detection result to the first PCB 427 through a cable 447.

In an embodiment of the disclosure, the electronic device 401 may easily form a space to dispose the temperature sensor 450 from the first opening 430 and the passage 435. The passage 435 may be formed from the first opening 430 along the second opening 443 of the inner rear member 415 to the sub-PCB 440, and the temperature sensor 450 may be disposed in the second opening 443. Since the electronic device 401 utilizes the first opening 430 and the passage 435 to measure the external temperature, and the passage 435 is a space to dispose various components as described above, the electronic device 401 may have improved space efficiency in terms of the internal design.

Referring to FIG. 9C, the electronic device 401 in an embodiment may include a cap member 455 covering the temperature sensor 450. Since water or a foreign substance on the temperature sensor 450 may cause errors in the detection result of the temperature sensor 450, the cap member 455 may surround the outer surface of the temperature sensor 450 to prevent water or a foreign substance from being in direct contact with the temperature sensor 450. In various embodiments, the cap member 455 may include a material with high thermal conductivity or elasticity, for example, a resin material.

Referring to FIG. 9D, the electronic device 401 in an embodiment may include a mesh member 457 disposed in front of the temperature sensor 450. The mesh member 457 may be disposed between the second opening 443 and the passage 435 and prevent a foreign substance from entering the temperature sensor 450 from the outside. The mesh member 457 may at least partially include a mesh net of a metal material or an air-permeable material, and may be supported by the inner rear member 415.

An electronic device 201 according to various embodiments may include a housing 210 including a sound hole 270 and a passage 315 communicating with the sound hole 270, a PCB 320 disposed inside the housing 210, and including a first surface 321 having an open area 321a facing the passage 315, a second surface 322 opposite the first surface 321, and a PCB hole 323 formed in the open area 321a, a microphone element 330 disposed on the PCB hole 323, in the second surface 322 of the PCB 320, a temperature sensor 350 disposed on a side of the PCB hole 323, in the open area 321a of the first surface 321 of the PCB 320, and having a variable factor, including a numerical value that changes in response to a temperature of air received through the passage 315, and a processor 120 configured to detect a temperature outside the housing 210 based on a change in the numerical value of the variable factor of the temperature sensor 350.

In an embodiment, the housing 210 may include a front plate 211a, a rear plate 211b coupled to the front plate 211a, and including a camera hole 275, and a camera decoration 273 coupled to the rear plate 211b, disposed in the camera hole 275, and in which the sound hole 270 is formed, and the PCB 320 may be disposed so that the first surface 321 may face the camera decoration 273 and the second surface 322 may face the front plate 211a.

In an embodiment, the electronic device 201 may include a sealing member 279 connecting the first surface 321 of the PCB 320 and the camera decoration 273, and including a layer hole 279b, 279d surrounding at least a partial area of the open area 321a.

In an embodiment, the sealing member 279 may include a first sealing layer 279a disposed on the first surface 321 of the PCB 320, and including a first layer hole 279b surrounding the PCB hole 323 and the temperature sensor 350, and a second sealing layer 279c disposed between the first sealing layer 279a and the camera decoration 273, and including a second layer hole 279d communicating with the first layer hole 279b and the sound hole 270.

In an embodiment, the housing 210 may include a front plate 211a and a rear plate 211b coupled to the front plate 211a, and the PCB 320 may be disposed between the front plate 211a and the rear plate 211b.

In an embodiment, the housing 210 may include a plurality of side surfaces 211c extending from a front surface 210a to a rear surface 210b and including a left side surface211c-4, a right side surface 211c-3, an upper side surface 211c-2, and a lower side surface 211c-1, and the sound hole 270 may be formed in one of the plurality of side surfaces 211c.

In an embodiment, the sound hole 270 may be formed in the upper side surface 211c-2, and the PCB 320 may be a main PCB of the electronic device 201 positioned relatively more adjacent to the upper side surface 211c-2 than the lower side surface 211c-1.

In an embodiment, the sound hole 270 may be formed in the lower side surface 211c-1, and the PCB 320 may be a sub-PCB of the electronic device 201 positioned relatively more adjacent to the lower side surface 211c-1 than the upper side surface 211c-2.

In an embodiment, the PCB 320 may be disposed such that the first surface 321 may face the front plate 211a and the second surface 322 may face the rear plate 211b, and the passage 315 may be formed to penetrate through the front plate 211a and extend from the sound hole 270 to the first surface 321 of the PCB 320.

In an embodiment, the front plate 211a may include a rib area 211e protruding toward the first surface 321 to be in contact with the first surface 321 and supporting the PCB 320, and the rib area 211e may be in contact with the first surface 321 at a position farther from the PCB hole 323 than the temperature sensor 350.

In an embodiment, the rib area 211e may be in contact with the first surface 321 to be non-overlapping with the microphone element 330, based on a state in which the first surface 321 is viewed.

In an embodiment, the microphone element 330 may include a microphone board 331 connected to the second surface 322 of the PCB 320, and including a microphone hole 331a communicating with the PCB hole 323, a transducer 332 disposed on the microphone board 331 to receive a sound through the microphone hole 331a, a cover member 336 configured to protect a surface, opposite the PCB 320, of the microphone board 331, a sealing area 337 configured to seal between the microphone board 331 and the cover member 336, and a contact area 338 connecting the transducer 332 and the microphone board 331.

The temperature sensor 350 is disposed on the PCB 320 to be non-overlapping with the contact area 338 of the microphone element 330, based on a state in which the first surface 321 is viewed.

In an embodiment, the temperature sensor 350 may be disposed on the PCB 320 to be non-overlapping with the sealing area 337 of the microphone element 330, based on the state when the first surface 321 is viewed.

In an embodiment, the electronic device 201 may include a cap member 355 covering the temperature sensor 350 on the first surface 321 of the PCB 320 and including a resin material.

An electronic device 201 in various embodiments may include a housing 210 including a sound hole 270 and a passage 315 communicating with the sound hole 270, a PCB 320 disposed inside the housing 210, and including a first surface 321 having an open area 321a facing the passage 315 and a second surface 322 opposite the first surface 321, a receiver 340 with at least a partial area facing the passage 315, the receiver configured to output a sound through the passage 315, a temperature sensor 350 having a variable factor, including a numerical value that changes in response to a temperature of air received through the passage 315, in the open area 321a of the first surface 321 of the PCB 320, and a processor 120 configured to detect a temperature outside the housing 210 based on a change in the numerical value of the variable factor of the temperature sensor 350.

In an embodiment, the electronic device 201 may include a mesh member 345 disposed between the sound hole 270, and the temperature sensor 350 and the receiver 340, and configured to prevent a foreign substance from entering from an outside of the sound hole 270.

In an embodiment, the electronic device 201 may include a cap member 355 covering the temperature sensor 350 on the first surface 321 of the PCB 320 and including a resin material.

In an embodiment, in the electronic device 201 and the processor 120 may control a drive of the receiver 340, and adjust a detection result of the temperature sensor 350 through a correction algorithm for correcting a detection result of the temperature sensor 350 based on an operation of the receiver 340.

In an embodiment, the processor 120 may correct the detection result according to the correction algorithm based on whether the receiver 340 is driven within a predetermined time from a timepoint of detection by the temperature sensor 350 and a length of a driving time of the receiver 340.

While embodiments have been illustrated and described above, the present disclosure is not limited to the aforementioned specific embodiments. Those skilled in the art should appreciate that various modifications can be made to the embodiments without departing from the subject matter of the present disclosure as defined by the appended claims.

## Claims

1. An electronic device (101, 201, 401) comprising:
a housing (210) comprising a sound hole (270) and a passage communicating with the sound hole;
a printed circuit board, PCB, (320) disposed inside the housing, and comprising a first surface (321) having an open area facing the passage, a second surface (322) opposite the first surface, and a PCB hole (323) formed in the open area;
a microphone element (330) disposed on the PCB hole, in the second surface of the PCB;
a temperature sensor (350) disposed on a side of the PCB hole, in the open area of the first surface of the PCB, and having a variable factor, comprising a numerical value that changes in response to a temperature of air received through the passage; and
a processor (120) configured to detect a temperature outside the housing based on a change in the numerical value of the variable factor of the temperature sensor,
wherein the microphone element comprises:
a microphone board (331) comprising a microphone hole (331a) communicating with the PCB hole;
a transducer (332) disposed on the microphone board to receive a sound through the microphone hole;
a contact area (338) connecting the transducer and the microphone board,
wherein the temperature sensor is disposed on the PCB to be non-overlapping with the contact area of the microphone element, based on a state in which the first surface is viewed.

2. The electronic device of claim 1, wherein the housing comprises:
a front plate (211a),
a rear plate (211b) coupled to the front plate, and
comprising a camera hole (275), and
a camera decoration (273) coupled to the rear plate, disposed in the camera hole, and in which the sound hole (270) is formed, and
wherein the PCB (320) is disposed so that the first surface (321) faces the camera decoration and the second surface (322) faces the front plate.

3. The electronic device of claim 2, comprising:
a sealing member (279) connecting the first surface (321) of the PCB (320) and the camera decoration (273), and comprising a layer hole (279b, 279d) surrounding at least a partial area of the open area.

4. The electronic device of claim 3, wherein the sealing member (279) comprises:
a first sealing layer (279a) disposed on the first surface (321) of the PCB (320), and comprising a first layer hole (279b) surrounding the PCB hole (323) and the temperature sensor (350); and
a second sealing layer (279c) disposed between the first sealing layer and the camera decoration (273), and comprising a second layer hole (279d) communicating with the first layer hole and the sound hole (270).

5. The electronic device of any one of claims 1 to 4,
wherein the housing comprises a front plate (211a) and a rear plate (211b) coupled to the front plate, and
wherein the PCB (320) is disposed between the front plate and the rear plate.

6. The electronic device of claim 1,
wherein the housing comprises a plurality of side surfaces extending from a front surface (210a) to a rear surface (210b) and comprising a left side surface (211c-4), a right side surface (211c-3), an upper side surface (211c-2), and a lower side surface (211c-1), and
wherein the sound hole (270) is formed in one of the plurality of side surfaces.

7. The electronic device of claim 6,
wherein the sound hole (270) is formed in the upper side surface (211c-2), and
wherein the PCB (320) is a main PCB of the electronic device positioned relatively more adjacent to the upper side surface than the lower side surface (211c-1).

8. The electronic device of claim 6,
wherein the sound hole (270) is formed in the lower side surface (211c-1), and
wherein the PCB (320) is a sub-PCB of the electronic device positioned relatively more adjacent to the lower side surface than the upper side surface (211c-2).

9. The electronic device of any one of claims 1 to 8,
wherein the PCB (320) is disposed such that the first surface (321) faces the front plate (211a) and the second surface (322) faces the rear plate (211b), and
wherein the passage (315) is formed to penetrate through the front plate and extends from the sound hole (270) to the first surface of the PCB.

10. The electronic device of any one of claims 2 or 5,
wherein the front plate (211a) comprises a rib area (211e) protruding toward the first surface to be in contact with the first surface and supporting the PCB, and
wherein the rib area is in contact with the first surface at a position farther from the PCB hole than the temperature sensor.

11. The electronic device of claim 10, wherein the rib area (211e) is in contact with the first surface (321) to be non-overlapping with the microphone element (330) based on a state in which the first surface is viewed.

12. The electronic device of any of claims 1 to 11, wherein the microphone element (330) further comprises:
a cover member (336) configured to protect a surface, opposite the PCB (320), of the microphone board, and
a sealing area (337) configured to seal between the microphone board and the cover member.

13. The electronic device of claim 12, wherein the temperature sensor (350) is disposed on the PCB (320) to be non-overlapping with the sealing area (337) of the microphone element (330), based on the state when the first surface (321) is viewed.

14. The electronic device of any one of claims 1 to 13, wherein the electronic device comprises a cap member (355) covering the temperature sensor (350) on the first surface (321) of the PCB (320) and comprising a resin material.

## Patentansprüche

1. Elektronische Vorrichtung (101, 201, 401), die Folgendes umfasst:
ein Gehäuse (210), das ein Schallloch (270) und einen Durchgang umfasst, der mit dem Schallloch in Verbindung steht;
eine Leiterplatte, PCB, (320), die in dem Gehäuse angeordnet ist und eine erste Oberfläche (321) mit einem dem Durchgang zugewandten offenen Bereich, eine zweite Oberfläche (322) gegenüber der ersten Oberfläche und ein in dem offenen Bereich ausgebildetes PCB-Loch (323) umfasst;
ein Mikrofonelement (330), das auf dem PCB-Loch in der zweiten Oberfläche der PCB angeordnet ist;
einen Temperatursensor (350), der an einer Seite des PCB-Lochs in dem offenen Bereich der ersten Oberfläche der PCB angeordnet ist und einen variablen Faktor aufweist, der einen numerischen Wert umfasst, der sich als Reaktion auf eine Temperatur der durch den Durchgang empfangenen Luft ändert; und
einen Prozessor (120), der so konfiguriert ist, dass er eine Temperatur außerhalb des Gehäuses basierend auf einer Änderung des numerischen Werts des variablen Faktors des Temperatursensors erkennt,
wobei das Mikrofonelement Folgendes umfasst:
eine Mikrofonplatine (331), die ein Mikrofonloch (331a) umfasst, das mit dem PCB-Loch in Verbindung steht;
einen Wandler (332), der auf der Mikrofonplatine so angeordnet ist, dass er einen Schall durch das Mikrofonloch empfängt;
eine Kontaktfläche (338), die den Wandler und die Mikrofonplatine verbindet,
wobei der Temperatursensor so auf der PCB angeordnet ist, dass er nicht mit der Kontaktfläche des Mikrofonelements überlappt, basierend auf einem Zustand, in dem die erste Oberfläche betrachtet wird.

2. Elektronische Vorrichtung nach Anspruch 1, wobei das Gehäuse Folgendes umfasst:
eine vordere Platte (211a),
eine hintere Platte (211b), die mit der vorderen Platte gekoppelt ist, und
ein Kameraloch (275), und
eine Kameradekoration (273) umfasst, die mit der hinteren Platte gekoppelt ist, in dem Kameraloch angeordnet ist und in der das Schallloch (270) ausgebildet ist, und
wobei die PCB (320) so angeordnet ist, dass die erste Oberfläche (321) der Kameradekoration zugewandt ist und die zweite Oberfläche (322) der vorderen Platte zugewandt ist.

3. Elektronische Vorrichtung nach Anspruch 2, die Folgendes umfasst:
ein Dichtungselement (279), das die erste Oberfläche (321) der PCB (320) mit der Kameradekoration (273) verbindet und ein Schichtloch (279b, 279d) umfasst, das zumindest einen Teilbereich des offenen Bereichs umgibt.

4. Elektronische Vorrichtung nach Anspruch 3, wobei das Dichtungselement (279) Folgendes umfasst:
eine erste Dichtungsschicht (279a), die auf der ersten Oberfläche (321) der PCB (320) angeordnet ist und ein erstes Schichtloch (279b) umfasst, das das PCB-Loch (323) und den Temperatursensor (350) umgibt; und
eine zweite Dichtungsschicht (279c), die zwischen der ersten Dichtungsschicht und der Kameradekoration (273) angeordnet ist und ein zweites Schichtloch (279d) umfasst, das mit dem ersten Schichtloch und dem Schallloch (270) in Verbindung steht.

5. Elektronische Vorrichtung nach einem der Ansprüche 1 bis 4,
wobei das Gehäuse eine vordere Platte (211a) und eine hintere Platte (211b) umfasst, die mit der vorderen Platte gekoppelt ist, und
wobei die PCB (320) zwischen der vorderen Platte und der hinteren Platte angeordnet ist.

6. Elektronische Vorrichtung nach Anspruch 1,
wobei das Gehäuse eine Vielzahl von Seitenflächen umfasst, die sich von einer Vorderseite (210a) zu einer Rückseite (210b) erstrecken und eine linke Seitenfläche (211c-4), eine rechte Seitenfläche (211c-3), eine obere Seitenfläche (211c-2) und eine untere Seitenfläche (211c-1) umfassen, und
wobei das Schallloch (270) in einer der Vielzahl von Seitenflächen ausgebildet ist.

7. Elektronische Vorrichtung nach Anspruch 6,
wobei das Schallloch (270) in der oberen Seitenfläche (211c-2) ausgebildet ist, und
wobei die PCB (320) eine Haupt-PCB der elektronischen Vorrichtung ist, die relativ näher an der oberen Seitenfläche als an der unteren Seitenfläche (211c-1) angeordnet ist.

8. Elektronische Vorrichtung nach Anspruch 6,
wobei das Schallloch (270) in der unteren Seitenfläche (211c-1) ausgebildet ist, und
wobei die PCB (320) eine Unter-PCB der elektronischen Vorrichtung ist, die relativ näher an der unteren Seitenfläche als an der oberen Seitenfläche (211c-2) angeordnet ist.

9. Elektronische Vorrichtung nach einem der Ansprüche 1 bis 8,
wobei die PCB (320) so angeordnet ist, dass die erste Oberfläche (321) der vorderen Platte (211a) zugewandt ist und die zweite Oberfläche (322) der hinteren Platte (211b) zugewandt ist, und
wobei der Durchgang (315) so ausgebildet ist, dass er die vordere Platte durchdringt und sich von dem Schallloch (270) zu der ersten Oberfläche der PCB erstreckt.

10. Elektronische Vorrichtung nach einem der Ansprüche 2 oder 5,
wobei die vordere Platte (211a) einen Rippenbereich (211e) umfasst, der in Richtung der ersten Oberfläche so vorsteht, dass er mit der ersten Oberfläche in Verbindung steht und die PCB stützt, und
wobei der Rippenbereich mit der ersten Oberfläche an einer Stelle in Verbindung steht, die von dem PCB-Loch weiter als der Temperatursensor entfernt ist.

11. Elektronische Vorrichtung nach Anspruch 10, wobei der Rippenbereich (211e) mit der ersten Oberfläche (321) so in Verbindung steht, dass er nicht mit dem Mikrofonelement (330) überlappt, basierend auf einem Zustand, in dem die erste Oberfläche betrachtet wird.

12. Elektronische Vorrichtung nach einem der Ansprüche 1 bis 11, wobei das Mikrofonelement (330) ferner Folgendes umfasst:
ein Abdeckelement (336), das so konfiguriert ist, dass es eine der PCB (320) gegenüberliegende Oberfläche der Mikrofonplatine schützt, und
einen Dichtungsbereich (337), der so konfiguriert ist, dass er zwischen der Mikrofonplatine und dem Abdeckelement abdichtet.

13. Elektronische Vorrichtung nach Anspruch 12, wobei der Temperatursensor (350) auf der PCB (320) so angeordnet ist, dass er nicht mit dem Dichtungsbereich (337) des Mikrofonelements (330) überlappt, basierend auf dem Zustand, in dem die erste Oberfläche (321) betrachtet wird.

14. Elektronische Vorrichtung nach einem der Ansprüche 1 bis 13, wobei die elektronische Vorrichtung ein Kappenelement (355) umfasst, das den Temperatursensor (350) auf der ersten Oberfläche (321) der PCB (320) abdeckt und ein Harzmaterial umfasst.

## Revendications

1. Dispositif électronique (101, 201, 401) comprenant :
un boîtier (210) comprenant un orifice sonore (270) et un passage communiquant avec l'orifice sonore ;
une carte de circuit imprimé, PCB, (320) disposée à l'intérieur du boîtier, et comprenant une première surface (321) ayant une zone ouverte faisant face au passage, une deuxième surface (322) opposée à la première surface, et un orifice PCB (323) formé dans la zone ouverte ;
un élément de microphone (330) disposé sur l'orifice PCB, dans la deuxième surface de la PCB ;
un capteur de température (350) disposé sur un côté de l'orifice PCB, dans la zone ouverte de la première surface de la PCB, et ayant un facteur variable, comprenant une valeur numérique qui varie en fonction d'une température de l'air reçu à travers le passage ; et
un processeur (120) configuré pour détecter une température extérieure au boîtier en fonction d'une variation de la valeur numérique du facteur variable du capteur de température,
où l'élément de microphone comprend :
une carte de microphone (331) comprenant un orifice de microphone (331a) communiquant avec l'orifice PCB ;
un transducteur (332) disposé sur la carte de microphone pour recevoir un son à travers l'orifice de microphone ;
une zone de contact (338) connectant le transducteur et la carte de microphone,
où le capteur de température est disposé sur la PCB de manière à ne pas chevaucher la zone de contact de l'élément de microphone, sur la base d'un état dans lequel la première surface est vue.

2. Dispositif électronique selon la revendication 1, où le boîtier comprend :
une plaque avant (211a),
une plaque arrière (211b) couplée à la plaque avant, et
comprenant un orifice de caméra (275), et
une décoration de caméra (273) couplée à la plaque arrière, disposée dans l'orifice de caméra, et dans laquelle est formé l'orifice sonore (270),
et
où la PCB (320) est disposée de sorte que la première surface (321) fait face à la décoration de caméra et la deuxième surface (322) fait face à la plaque avant.

3. Dispositif électronique selon la revendication 2, comprenant :
un élément d'étanchéité (279) connectant la première surface (321) de la PCB (320) et la décoration de caméra (273), et comprenant un orifice de couche (279b, 279d) entourant au moins une zone partielle de la zone ouverte.

4. Dispositif électronique selon la revendication 3, où l'élément d'étanchéité (279) comprend :
une première couche d'étanchéité (279a) disposée sur la première surface (321) de la PCB (320), et comprenant un premier trou de couche (279b) entourant l'orifice PCB (323) et le capteur de température (350) ; et
une deuxième couche d'étanchéité (279c) disposée entre la première couche d'étanchéité et la décoration de caméra (273), et comprenant un deuxième trou de couche (279d) communiquant avec le premier trou de couche et l'orifice sonore (270).

5. Dispositif électronique selon l'une quelconque des revendications 1 à 4,
où le boîtier comprend une plaque avant (211a) et une plaque arrière (211b) couplée à la plaque avant, et
où la PCB (320) est disposée entre la plaque avant et la plaque arrière.

6. Dispositif électronique selon la revendication 1,
où le boîtier comprend une pluralité de surfaces latérales s'étendant d'une surface avant (210a) à une surface arrière (210b) et comprenant une surface latérale gauche (211c-4), une surface latérale droite (211c-3), une surface latérale supérieure (211c-2), et une surface latérale inférieure (211c-1), et
où l'orifice sonore (270) est formé dans l'une des surfaces de la pluralité de surfaces latérales.

7. Dispositif électronique selon la revendication 6,
où l'orifice sonore (270) est formé dans la surface latérale supérieure (211c-2), et
où la PCB (320) est une PCB principale du dispositif électronique positionnée relativement plus près de la surface latérale supérieure que de la surface latérale inférieure (211c-1).

8. Dispositif électronique selon la revendication 6,
où l'orifice sonore (270) est formé dans la surface latérale inférieure (211c-1), et
où la PCB (320) est une sous-PCB du dispositif électronique positionnée relativement plus près de la surface latérale inférieure que de la surface latérale supérieure (211c-2).

9. Dispositif électronique selon l'une quelconque des revendications 1 à 8,
où la PCB (320) est disposée de sorte que la première surface (321) fait face à la plaque avant (211a) et la deuxième surface (322) fait face à la plaque arrière (211b), et
où le passage (315) est formé pour traverser la plaque avant et s'étend de l'orifice sonore (270) à la première surface de la PCB.

10. Dispositif électronique selon l'une quelconque des revendications 2 ou 5,
où la plaque avant (211a) comprend une zone de nervure (211e) faisant saillie vers la première surface de manière à être en contact avec la première surface et supportant la PCB, et
où la zone de nervure est en contact avec la première surface à une position plus éloignée de l'orifice PCB que le capteur de température.

11. Dispositif électronique selon la revendication 10, où la zone de nervure (211e) est en contact avec la première surface (321) de manière à ne pas chevaucher l'élément de microphone (330) sur la base d'un état dans lequel la première surface est vue.

12. Dispositif électronique selon l'une quelconque des revendications 1 à 11, où l'élément de microphone (330) comprend en outre :
un élément de recouvrement (336) configuré pour protéger une surface, opposée à la PCB (320), de la carte de microphone, et
une zone d'étanchéité (337) configurée pour assurer l'étanchéité entre la carte de microphone et l'élément de recouvrement.

13. Dispositif électronique selon la revendication 12, où le capteur de température (350) est disposé sur la PCB (320) de manière à ne pas chevaucher la zone d'étanchéité (337) de l'élément de microphone (330), sur la base de l'état dans lequel la première surface (321) est vue.

14. Dispositif électronique selon l'une quelconque des revendications 1 à 13, où le dispositif électronique comprend un élément de couvercle (355) recouvrant le capteur de température (350) sur la première surface (321) de la PCB (320) et comprenant un matériau en résine.
